# FASCICULE DE BREVET EUROPEEN

(11) **EP 0 872 959 B1**
(45) Date de publication et mention de la délivrance du brevet: **10.12.2003**
(21) Numéro de dépôt: 98201149.6
(22) Date de dépôt: 09.04.1998
(51) Int. Cl.: H03K 23/54, H03J 5/02

(54) **Diviseur de fréquence à faible bruit.**
Rauscharmer Frequenzteiler
Low noise frequency divider

(30) Priorité: 15.04.1997 FR 9704598
(43) Date de publication de la demande: 21.10.1998
(73) Titulaire: Koninklijke Philips Electronics N.V., 5621 BA Eindhoven (NL)
(72) Inventeur: Canard, David, 75008 Paris (FR); Fillatre, Vincent, 75008 Paris (FR)
(74) Mandataire: Charpail, François

(56) Documents cités:
- PATENT ABSTRACTS OF JAPAN vol. 3, no. 107 (E-136), 8 septembre 1979 & JP 54 084471 A (TOKYO SHIBAURA DENKI K.K.), 7 mai 1979,
- MOLLER K -D: "PLL-SYNTHESIZERSCHALTKREIS U 1056 D" RADIO FERNSEHEN ELEKTRONIK, vol. 39, no. 4, 1 janvier 1990, pages 230, 261-263, XP000127902
- PATENT ABSTRACTS OF JAPAN vol. 096, no. 004, 30 avril 1996 & JP 07 321642 A (NEC CORP), 8 décembre 1995,

## Description

La présente invention concerne un circuit intégré tel que défini par le préambule de la revendication 1.

Un circuit intégré comportant un diviseur de fréquence est décrit dans l'article "Frequency dividers for ultra-high frequencies" de Mr. W.D. Kasperkovitz, paru dans Philips Technical Review 38 54-68, 1978/79 No.2. Cet article présente l'architecture d'une bascule mémoire réalisée en technologie ECL, ainsi qu'un diviseur par deux mettant en oeuvre deux de ces bascules. Chacune de celles-ci comporte un premier et un deuxième transistors constituant une première paire différentielle, dont les émetteurs sont reliés ensemble, via une source de courant, à une borne négative d'alimentation, et dont les bases forment l'entrée symétrique d'horloge de la bascule mémoire. Chaque bascule mémoire comporte en outre un troisième et un quatrième transistors constituant une deuxième paire différentielle, dont les émetteurs sont reliés ensemble au collecteur du premier transistor, dont les bases forment l'entrée symétrique de données de la bascule mémoire, et dont les collecteurs sont reliés, via des résistances de charge, à une borne positive d'alimentation. Chaque bascule mémoire comporte enfin un cinquième et un sixième transistors constituant une troisième paire différentielle, dont les émetteurs sont reliés ensemble au collecteur du deuxième transistor, dont les bases sont respectivement connectées aux collecteurs des quatrième et troisième transistors, et dont les collecteurs sont respectivement reliés aux collecteurs des troisième et quatrième transistors.

Le diviseur par deux décrit dans cet article comporte deux de ces bascules. La sortie de données de la première bascule mémoire est reliée à l'entrée de données de la deuxième bascule mémoire, la sortie de données de la deuxième bascule mémoire étant connectée avec croisement à l'entrée de données de la première bascule mémoire, la sortie de données de la deuxième bascule mémoire constituant, dans ce mode de réalisation, la sortie du circuit diviseur de fréquence, l'entrée d'horloge de la première bascule mémoire étant reliée à l'entrée du circuit diviseur de fréquence, l'entrée d'horloge de la deuxième bascule mémoire étant connectée avec croisement à la dite entrée. Il est possible d'utiliser un tel diviseur par deux pour réaliser un circuit diviseur de fréquence présentant pour rapport de division un nombre égal à 2^{M}, où M est un nombre entier quelconque, en disposant en cascade M diviseurs par deux conformes à la structure précédemment décrite, le premier diviseur par deux recevant sur son entrée un signal d'entrée, la sortie de chaque diviseur par deux étant reliée à l'entrée du diviseur par deux suivant, hormis la sortie du dernier diviseur par deux qui constitue la sortie du circuit diviseur de fréquence. Cette structure a pour avantage de pouvoir fonctionner à des fréquences très élevées, c'est-à-dire lorsque la fréquence du signal d'entrée est par exemple de l'ordre du GigaHertz. Elle présente toutefois des inconvénients majeurs. Les paires différentielles incluses dans les bascules mémoire de chaque diviseur par deux commutent à chaque demi-période de son signal d'entrée. Il s'ensuit l'apparition de pointes de courant débitées dans les bornes d'alimentation à chaque demi-période du signal d'entrée de chaque diviseur par deux. Ces pointes de courant constituent un bruit, c'est-à-dire des signaux parasites qui se propagent dans l'ensemble du circuit intégré, puisque tous les composants que celui-ci contient sont reliés directement ou indirectement aux bornes d'alimentation. Ce bruit présente autant d'harmoniques qu'il y a de diviseurs par deux disposés en cascade. Si certains de ces harmoniques n'ont que peu d'effet sur le fonctionnement du circuit intégré, d'autres peuvent être particulièrement néfastes pour celui-ci. Enfin, la structure décrite ci-dessus ne permet pas une division par un nombre pair qui ne constitue pas une puissance de deux.

L'invention a pour but de remédier dans une large mesure à ces inconvénients, en proposant un diviseur de fréquence qui génère un seul signal parasite ayant une unique fréquence quel que soit le rapport de division entre son signal d'entrée et son signal de sortie, le dit rapport pouvant être choisi comme un quelconque multiple de deux.

En effet, un circuit intégré comprenant un diviseur de fréquence selon l'invention est caractérisé en ce que le dit diviseur de fréquence comporte 2.N bascules mémoire du type précité, la sortie de données de la i_{ème} bascule mémoire, dite bascule de rang i, étant reliée, pour i=1 à 2.N-1, à l'entrée de données de la bascule de rang i+1, la sortie de données de la bascule de rang 2.N étant connectée avec croisement à l'entrée de données de la bascule de rang 1, la sortie de données de l'une des bascules constituant la sortie du circuit diviseur de fréquence, l'entrée d'horloge de chaque bascule de rang impair étant reliée à l'entrée du circuit diviseur de fréquence, l'entrée d'horloge de chaque bascule de rang pair étant connectée avec croisement à la dite entrée.

Les bascules mémoire incluses dans un tel diviseur de fréquence reçoivent toutes un même signal d'entrée ou son inverse. Par conséquent, le bruit généré dans les bornes d'alimentation ne présente qu'un seul harmonique dont la fréquence est égale au double de la fréquence du signal d'entrée du diviseur de fréquence, et ce quel que soit le rapport de division obtenu à l'aide de celui-ci. Un tel diviseur de fréquence constitue donc un filtre de signaux parasites qui n'autorise la génération que d'un seul harmonique. De plus, il permet une division de la valeur de la fréquence d'entrée par un nombre pair quelconque. Toutefois, un rapport de division de valeur 2.N implique l'utilisation de 2.N bascules mémoire. En comparaison avec une structure composée de diviseurs par deux connus disposés en cascade, un diviseur de fréquence conforme à l'invention est donc moins économique en termes de surface de silicium nécessaire à sa réalisation dès lors que 2.N>4. Il peut donc être avantageux de combiner les deux structures au sein d'un même diviseur de fréquence, qui comportera alors une succession de diviseurs par deux disposés en cascade, au sein desquels sera inséré au moins un diviseur de fréquence conforme à l'invention. La position occupée par le dit diviseur dans l'enchaînement des diviseurs par deux connus déterminera les harmoniques qui seront supprimés par celui-ci.

Un diviseur de fréquence tel que décrit ci-dessus peut être mis en oeuvre au sein d'un diviseur de fréquence programmable. Dans une de ses variantes, l'invention propose ainsi un circuit intégré comprenant un diviseur de fréquence programmable muni d'une première entrée destinée à recevoir un signal ayant une fréquence dite fréquence d'entrée, d'une deuxième entrée destinée à recevoir un signal dit de commande, et d'une sortie, le diviseur de fréquence programmable comportant :
. un premier diviseur de fréquence muni d'une entrée formant l'entrée du diviseur de fréquence programmable, et d'une sortie destinée à délivrer un signal ayant une fréquence dite intermédiaire dont la valeur est 2.P fois inférieure à celle de la fréquence d'entrée, où P est un nombre entier prédéterminé,
. un deuxième diviseur de fréquence muni d'une entrée reliée à la sortie du premier diviseur de fréquence, et d'une sortie formant la sortie du diviseur de fréquence programmable et destinée à délivrer un signal ayant une fréquence, dite de sortie, dont la valeur est K fois inférieure à celle de la fréquence intermédiaire, où K est un nombre réel dont la valeur est déterminée par la valeur du signal de commande, caractérisé en ce que, P étant supérieur ou égal à N, le premier diviseur de fréquence comporte au moins un circuit diviseur de fréquence tel que décrit plus haut.

La présence de diviseurs de fréquence selon l'invention, judicieusement disposés au sein du premier diviseur de fréquence permet le filtrage des signaux parasites dont les fréquences sont les plus néfastes, comme on le verra dans la suite de l'exposé.

Des dispositifs de sélection de fréquence, utilisés entre autres dans des récepteurs de télévision pour la sélection de signaux radio-électriques, mettent en oeuvre des diviseurs de fréquence programmables, notamment dans des boucles dites à verrouillage de phase permettant la sélection d'un signal radio-électrique particulier.

L'invention concerne donc également un dispositif de sélection muni d'une entrée dite de signal destinée à recevoir un signal radio-électrique, d'une deuxième entrée dite de commande destinée à recevoir un signal de commande définissant la fréquence d'un signal radio-électrique à sélectionner, et d'une sortie, dispositif comportant :
. un oscillateur muni d'une entrée dite de réglage et d'une sortie destinée à délivrer un signal dont la fréquence dépend de la valeur d'un signal appliqué à son entrée de réglage,
. un mélangeur muni d'une première entrée, formant l'entrée de signal du dispositif, d'une deuxième entrée reliée à la sortie de l'oscillateur, et d'une sortie, formant la sortie du dispositif, destinée à délivrer un signal dont la fréquence est égale à la différence entre la fréquence du signal reçu sur sa première entrée et celle du signal reçu sur sa deuxième entrée,
. un diviseur de fréquence programmable muni d'une première entrée reliée à la sortie de l'oscillateur, d'une deuxième entrée formant l'entrée de commande du dispositif, et d'une sortie destinée à délivrer un signal dont la fréquence est définie par la valeur du signal de commande,
. un détecteur de phase, muni d'une première entrée destinée à recevoir un signal dit de référence dont la fréquence est fixe, d'une deuxième entrée reliée à la sortie du diviseur de fréquence, et d'une sortie reliée à l'entrée de réglage de l'oscillateur, et muni de moyens pour délivrer sur sa sortie un signal dont la valeur dépend de la différence entre les phases de ses signaux d'entrée,
dispositif caractérisé en ce que le diviseur de fréquence programmable est tel que décrit ci-dessus.

Les harmoniques les plus néfastes au fonctionnement de ce dispositif de sélection sont notamment ceux ayant des fréquences égales à la fréquence du signal de sortie de l'oscillateur, au quart et au huitième de la dite fréquence. Un filtrage de ces harmoniques peut être réalisé grâce à la présente invention.

L'invention sera mieux comprise à l'aide de la description suivante de quelques modes de réalisation, faite à titre d'exemple non-limitatif et en regard des dessins annexés, dans lesquels :
- la figure 1 est un schéma électrique décrivant une bascule mémoire connue réalisée en technologie ECL,
- la figure 2 est un schéma fonctionnel décrivant un diviseur de fréquence connu,
- la figure 3 est un schéma fonctionnel décrivant un diviseur de fréquence selon l'invention,
- la figure 4 est un ensemble de chronogrammes décrivant l'évolution de signaux présents dans un diviseur de fréquence selon l'invention,
- la figure 5 est un schéma fonctionnel décrivant un diviseur de fréquence programmable selon une variante de l'invention, et
- la figure 6 est un schéma fonctionnel décrivant un dispositif de sélection mettant en oeuvre un diviseur de fréquence programmable selon l'invention.

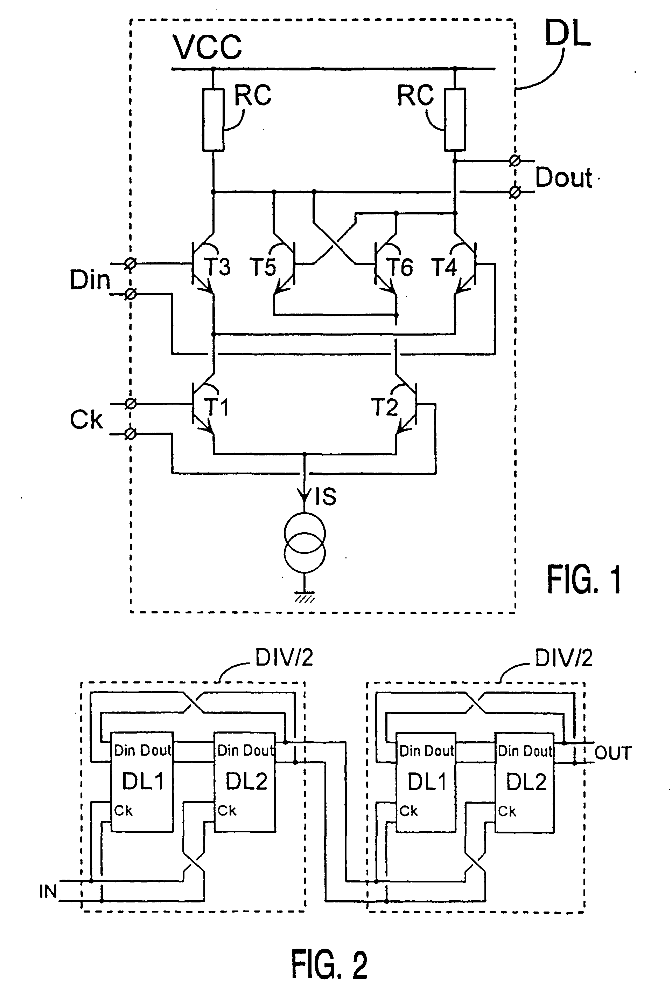

La figure 1 représente schématiquement une bascule mémoire DL connue réalisée en technologie ECL. Cette bascule mémoire DL comporte un premier et un deuxième transistors, T1 et T2, constituant une première paire différentielle, dont les émetteurs sont reliés ensemble, via une source de courant destinée à débiter un courant IS, à une borne négative d'alimentation constituée ici par la masse du circuit, et dont les bases forment une entrée symétrique d'horloge Ck de la bascule mémoire DL. La bascule mémoire DL comporte en outre un troisième et un quatrième transistors, T3 et T4, constituant une deuxième paire différentielle, dont les émetteurs sont reliés ensemble au collecteur du premier transistor T1, dont les bases forment une entrée symétrique de données Din de la bascule mémoire DL, et dont les collecteurs sont reliés, via des résistances de charge RC, à une borne positive d'alimentation VCC. La bascule mémoire DL comporte enfin un cinquième et un sixième transistors, T5 et T6, constituant une troisième paire différentielle, dont les émetteurs sont reliés ensemble au collecteur du deuxième transistor T2, dont les bases sont respectivement connectées aux collecteurs des quatrième et troisième transistors, T4 et T3, et dont les collecteurs, respectivement reliés aux collecteurs des troisième et quatrième transistors T3 et T4, forment une sortie symétrique de données Dout de la bascule mémoire DL.

Lorsque l'entrée d'horloge Ck reçoit un signal d'horloge positif, le premier transistor T1 est conducteur alors que le deuxième transistor T2 est bloqué. Le premier transistor T1 active alors la deuxième paire différentielle, c'est-à-dire que l'état des troisième et quatrième transistors T3 et T4 qui la constituent est déterminé par l'état d'un signal de données appliqué sur l'entrée de données Din de la bascule mémoire DL. Si, par exemple, ce signal de données est positif, le troisième transistor T3 conduit tandis que le quatrième transistor T4 est bloqué. La bascule mémoire DL délivre alors sur sa sortie de données Dout un signal positif. Lorsque le signal d'horloge devient négatif, la deuxième paire de transistors T3, T4 est désactivée, car le premier transistor T1 est bloqué, mais, le deuxième transistor T2 étant alors conducteur, la troisième paire de transistors T5, T6, est activée. Le potentiel du collecteur du troisième transistor T3 est alors appliqué à la base du sixième transistor T6, tandis que celui du quatrième transistor T4 est appliqué à la base du cinquième transistor T5. Les cinquième et sixième transistors T5 et T6 sont donc respectivement conducteur et bloqué, dans ce cas, lorsque le signal d'horloge devient négatif après que l'entrée de données Din ait reçu un signal positif pendant un état positif du signal d'horloge. Le signal délivré par la bascule mémoire DL à sa sortie de données Dout reste donc positif. Le signal qui a été appliqué à l'entrée de données Din de la bascule mémoire DL est donc mémorisé pendant au moins un cycle du signal d'horloge appliqué à la dite bascule mémoire. Un raisonnement en tout point similaire peut être appliqué au cas où un signal négatif serait appliqué à l'entrée de données Din de la bascule mémoire DL.

On constate donc que pendant un état positif du signal d'horloge, le premier transistor T1 conduit, et que pendant un état négatif du signal d'horloge, le deuxième transistor T2 conduit. Ceci signifie que, pendant un même cycle du signal d'horloge, les deuxième et troisième paires différentielles se trouvent activées alternativement par la mise en conduction des premier ou deuxième transistors, respectivement. Les transitions entre l'activation de l'une de ces paires différentielles et la désactivation de l'autre provoque l'apparition de signaux parasites dans les bornes d'alimentation, signaux parasites dont la fréquence est égale au double de la fréquence du signal d'horloge.

La figure 2 représente schématiquement un diviseur par quatre connu, constitué de deux diviseurs par deux DIV/2 disposés en cascade, chacun mettant en oeuvre deux bascules mémoire DL1 et DL2 telles que décrites ci-dessus. Au sein de chacun de ces diviseurs par deux DIV/2, la sortie de données Dout de la première bascule DL1 est reliée à l'entrée de données Din de la deuxième bascule DL2, la sortie de données Dout de la deuxième bascule mémoire DL2 étant connectée avec croisement à l'entrée de données Din de la première bascule DL1, la sortie de données Dout de la deuxième bascule constituant, dans ce mode de réalisation, la sortie du diviseur par deux DIV/2. L'entrée d'horloge Ck de la première bascule DL1 est reliée à l'entrée du diviseur par deux DIV/2, l'entrée d'horloge Ck de la deuxième bascule DL2 étant connectée avec croisement à la dite entrée. Les deux diviseurs par deux DIV/2 sont disposés en cascade, le premier diviseur par deux DIV/2 recevant sur son entrée un signal d'entrée IN, la sortie du dit premier diviseur par deux étant reliée à l'entrée du deuxième diviseur par deux DIV/2, dont la sortie constitue la sortie OUT du circuit diviseur de fréquence. Cette structure a pour avantage de pouvoir fonctionner à des fréquences très élevées, c'est-à-dire lorsque la fréquence du signal d'entrée est par exemple de l'ordre du GigaHertz. Ceci est dû à la rapidité de commutation des transistors bipolaires qui constituent les bascules mémoire DL en technologie ECL. Elle présente toutefois des désavantages en termes de bruit. Ainsi qu'exposé précédemment, les paires différentielles incluses dans les bascules mémoire DL1, DL2, de chaque diviseur par deux DIV/2 commutent à chaque demi-période du signal d'entrée. Il s'ensuit l'apparition de pointes de courant débitées vers les bornes d'alimentation à chaque demi-période du signal d'entrée de chaque diviseur par deux. Si la fréquence du signal appliqué à l'entrée IN du premier diviseur par deux DIV/2 est notée Fin, les paires différentielles du premier diviseur par deux DIV/2 génèrent un signal parasite à la fréquence 2.Fin dans les bornes d'alimentation, tandis que les paires différentielles du deuxième diviseur par deux DIV/2, qui reçoit sur son entrée un signal dont la fréquence est égale à Fin/2, génèrent, elles, un signal parasite à la fréquence Fin dans les bornes d'alimentation. Ces signaux parasites se propagent dans l'ensemble du circuit intégré, puisque tous les composants que celui-ci contient sont reliés directement ou indirectement aux dites bornes d'alimentation. Ces signaux parasites constituent un bruit qui présente donc ici deux harmoniques dont les fréquences respectives sont 2.Fin et Fin. Enfin, il apparaît clairement que la structure décrite ci-dessus ne permet par une division par un nombre pair qui ne constitue pas une puissance de deux, puisque la mise en cascade de M diviseurs par deux du type décrit ci-dessus donnera un rapport de division égal à 2^{M} entre la valeur de la fréquence du signal appliqué à son entrée IN et celle de la fréquence du signal délivré à sa sortie OUT.

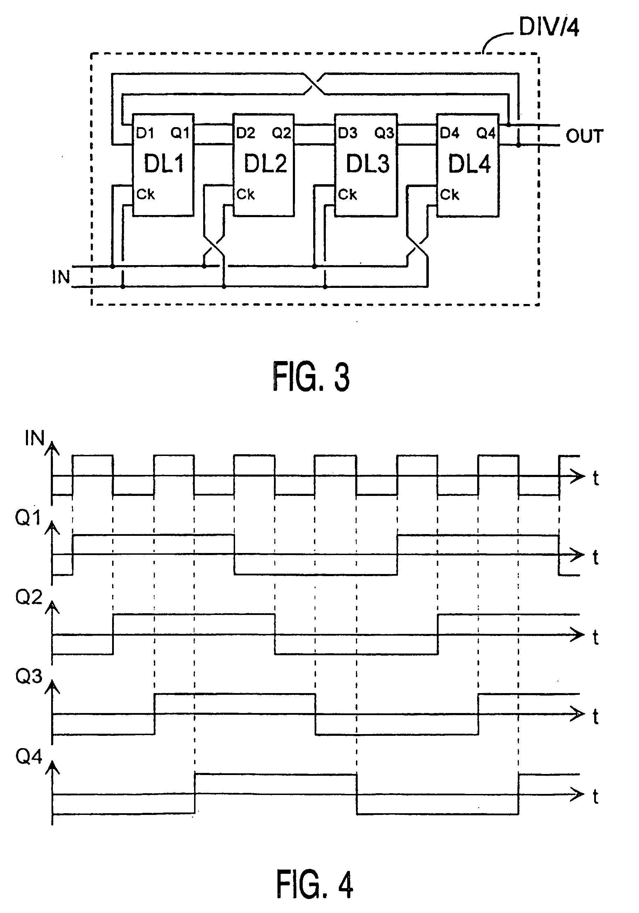

La figure 3 représente schématiquement un diviseur de fréquence DIV/4 conforme à l'invention, muni d'une entrée symétrique IN destinée à recevoir un signal ayant une fréquence Fin, et d'une sortie symétrique OUT destinée à délivrer un signal ayant une fréquence Fout, dont la valeur est 4 fois inférieure à celle de la première fréquence Fin. Ce diviseur de fréquence DIV/4 est composé de bascules mémoire réalisées en technologie ECL telles que décrites ci-dessus, chacune munie d'une entrée symétrique de données Di (pour i=1 à 4), d'une entrée symétrique d'horloge Ck et d'une sortie symétrique de données Qi (pour i=1 à 4). La sortie de données Qi de la i_{ème} bascule mémoire, dite bascule de rang i, est reliée, pour i=1 à 3, à l'entrée de données Di+1 dela bascule de rang i+1. La sortie de données Q4 de la bascule de rang 4 est connectée avec croisement à l'entrée de données D1 de la bascule de rang 1. La dite sortie de données Q4 constitue ici la sortie du circuit diviseur de fréquence DIV/4. L'entrée d'horloge Ck de chaque bascule de rang impair DL1, DL3, est reliée à l'entrée IN du circuit diviseur de fréquence DIV/4, l'entrée d'horloge Ck de chaque bascule de rang pair DL2, DL4, étant connectée avec croisement à la dite entrée.

La figure 4 est un ensemble de chronogrammes destiné à illustrer le fonctionnement d'un tel diviseur de fréquence. Si l'on choisit par exemple un état initial dans lequel la sortie Q4 de la quatrième bascule DL4 est négative lorsque le signal appliqué à l'entrée IN du diviseur est négatif, cela signifie que le signal présent à l'entrée de données D1 de la première bascule DL1 est positif. Lorsque le signal d'entrée devient positif, la première bascule DL1 duplique l'état positif appliqué sur son entrée de données D1 sur sa sortie de données Q1. Cet état positif est alors transmis à l'entrée de données D2 de la deuxième bascule DL2. Lorsque le signal d'entrée devient négatif, la première bascule DL1 mémorise l'état positif précédemment appliqué sur son entrée de données D1 et le restitue sur sa sortie de données Q1. La deuxième bascule DL2 duplique l'état positif appliqué sur son entrée de données D2 sur sa sortie de données Q2. Cet état positif est alors transmis à l'entrée de données D3 de la troisième bascule DL3. Ce processus se répète jusqu'à ce que la quatrième bascule DL4 duplique un état positif précédemment appliqué sur son entrée de données D4 sur sa sortie de données Q4. Le signal présent à l'entrée de données D1 de la première bascule DL1 devient alors négatif, et à l'état positif suivant du signal d'entrée du diviseur, la première bascule DL1 restitue l'état négatif appliqué sur son entrée de données D1 sur sa sortie de données Q1. Cet état négatif se propage ensuite au travers du diviseur selon un processus identique à celui décrit ci-dessus. On constate donc que chacune des sorties Qi des bascules mémoire DLi (pour i=1 à 4) délivre un signal périodique dont la période est quatre fois plus longue que celle du signal appliqué à l'entrée du diviseur de fréquence, ce qui équivaut à dire que la fréquence de chacun de ces signaux de sortie est égale à Fin/4 si Fin est la fréquence du signal appliqué à l'entrée du diviseur de fréquence. Par contre, du fait que toutes les bascules DLi (pour i=1 à 4) reçoivent un même signal d'entrée ou son inverse, tous deux de fréquence Fin, toutes les paires différentielles contenues dans le diviseur de fréquence commutent de manière synchrone deux fois au cours de chaque période du signal d'entrée, et ne génèrent donc qu'un unique signal parasite de fréquence 2.Fin dans les bornes d'alimentation. Plus généralement, la structure du diviseur de fréquence selon l'invention permet donc d'éliminer les signaux parasites dont les fréquences sont inférieures au double de la fréquence du signal qu'il reçoit sur son entrée, quel que soit le nombre de bascules mémoire qu'il contient. De plus, il est évident, à la lumière de la description qui a été faite du fonctionnement d'un diviseur par quatre, qu'une structure similaire comprenant un nombre 2.N quelconque de bascules mémoire permet de réaliser un rapport de division égal à 2.N, ce qui permet donc d'obtenir des rapports de divisions autres que des puissances de deux. On remarquera également qu'un diviseur de fréquence conforme à l'invention génère, sur chacune des sorties des 2.N bascules mémoire qu'il comporte, 2.N signaux successivement décalés en phase d'une valeur π/(2.N). Cette propriété pourra être avantageusement exploitée dans certaines applications où le diviseur de fréquence sera utilisé comme un générateur de sigaux déphasés.

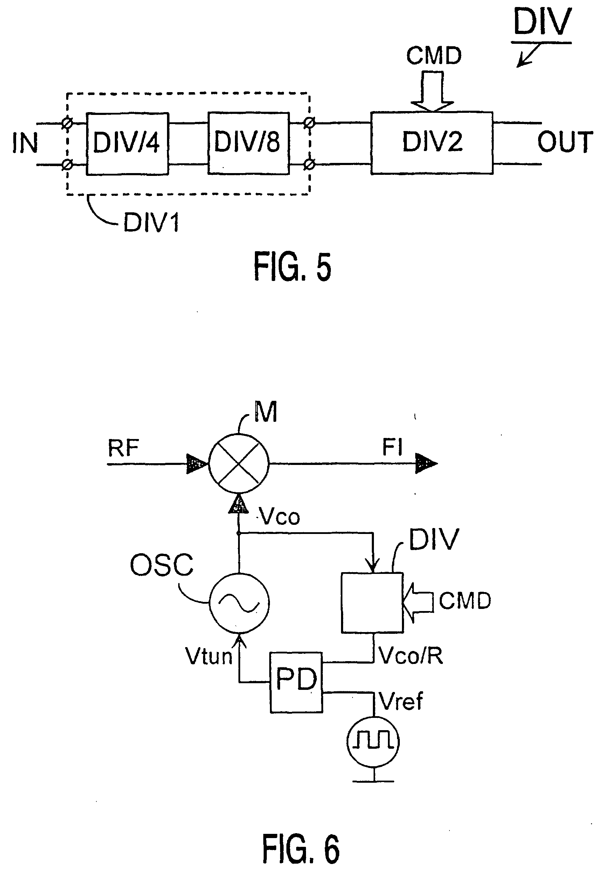

La figure 5 représente schématiquement un diviseur de fréquence programmable DIV selon une variante de l'invention, muni d'une première entrée IN destinée à recevoir un signal ayant une fréquence Fin dite fréquence d'entrée, d'une deuxième entrée destinée à recevoir un signal CMD dit de commande, et d'une sortie OUT. Ce diviseur de fréquence programmable DIV comporte :
. un premier diviseur de fréquence DIV1 muni d'une entrée formant l'entrée IN du diviseur de fréquence programmable DIV, et d'une sortie destinée à délivrer un signal ayant une fréquence dite intermédiaire dont la valeur est 32 fois inférieure à celle de la fréquence d'entrée Fin,
. un deuxième diviseur de fréquence DIV2 muni d'une entrée reliée à la sortie du premier diviseur de fréquence DIV1, et d'une sortie formant la sortie OUT du diviseur de fréquence programmable DIV et destinée à délivrer un signal ayant une fréquence Fout, dite de sortie, dont la valeur est K fois inférieure à celle de la fréquence intermédiaire Fin/32, où K est un nombre réel dont la valeur est déterminée par la valeur du signal de commande CMD.

Le premier diviseur de fréquence DIV1 comporte un diviseur de fréquence DIV/4 conforme à l'invention et tel que décrit ci-dessus, présentant un rapport de division égal à 4, et un diviseur de fréquence DIV/8 conforme à l'invention et présentant un rapport de division égal à 8.

Le rapport de division R=Fin/Fout obtenu à l'aide de ce diviseur programmable DIV est égal à 32.K. La réalisation du premier diviseur de fréquence nécessite l'utilisation de 4 bascules mémoire pour DIV/4 et 8 bascules mémoire pour DIV/8. Un rapport de division égal à 32 aurait pu être obtenu à l'aide de cinq diviseurs par deux connus disposés en cascade, soit 10 bascules mémoire. Un tel agencement aurait toutefois généré des signaux parasites ayant pour harmoniques 2.Fin, Fin, Fin/2, Fin/4 et Fin/8. Le diviseur de fréquence DIV1 ne génère, conformément à ce qui a été décrit plus haut, que deux harmoniques 2.Fin et Fin/2. Bien que la structure du diviseur de fréquence soit plus encombrante que la structure connue, la plus grande pureté spectrale qu'elle procure la rend très avantageuse, particulièrement aux hautes fréquences. De plus, le filtrage qu'elle rend possible est aisément adaptable. Ainsi, dans l'exemple décrit ici, une permutation des deux diviseurs DIV/4 et DIV/8 permettrait, pour un même rapport de division égal à 32, de ne conserver que les harmoniques 2.Fin et Fin/4, dans une application où ceux-ci s'avéreraient les moins néfastes au fonctionnement du circuit.

La figure 6 représente schématiquement un dispositif de sélection mettant en oeuvre un diviseur de fréquence programmable selon l'invention. Ce dispositif est muni d'une entrée dite de signal recevant un signal radio-électrique RF dont la fréquence est appelée fréquence radio. Le dispositif est en outre muni d'une entrée dite de commande recevant un signal de commande CMD définissant la fréquence d'un signal radio-électrique à sélectionner au sein d'un ensemble de signaux dont les fréquences radio sont situées dans une gamme donnée. Le dispositif est de plus muni d'une sortie délivrant un signal FI ayant une fréquence, appelée fréquence intermédiaire, fixée. Le dispositif comporte :
. un oscillateur OSC muni d'une entrée dite de réglage, et d'une sortie délivrant un signal Vco dont la fréquence, notée FLO, dépend de la valeur d'un signal de réglage Vtun appliqué à son entrée de réglage,
. un mélangeur M muni d'une première entrée, formant l'entrée de signal du dispositif, et recevant le signal radio-électrique RF, d'une deuxième entrée reliée à la sortie de l'oscillateur OSC, et d'une sortie, formant la sortie du dispositif, délivrant un signal FI dont la fréquence intermédiaire est égale à la différence entre la fréquence du signal RF reçu sur sa première entrée et celle du signal Vco reçu sur sa deuxième entrée,
. un diviseur de fréquence programmable DIV muni d'une première entrée reliée à la sortie de l'oscillateur OSC, d'une deuxième entrée formant l'entrée de commande du dispositif, et d'une sortie délivrant un signal Vco/R dont la fréquence est égale à la fréquence du signal Vco reçu sur la première entrée, divisée par un nombre défini par le signal de commande CMD reçu sur la deuxième entrée,
. un détecteur de phase PD, muni d'une première entrée recevant un signal Vref dit de référence dont la fréquence est fixe, d'une deuxième entrée reliée à la sortie du diviseur de fréquence DIV, et d'une sortie reliée à l'entrée de réglage de l'oscillateur OSC, et muni de moyens pour délivrer sur sa sortie le signal Vtun dont la valeur dépend de la différence entre les phases de ses signaux d'entrée.

Dans un tel dispositif, le choix du rapport entre la fréquence du signal de sortie Vco de l'oscillateur OSC et celle du signal de sortie Vco/R du diviseur de fréquence DIV, rapport que l'on notera R, permet la sélection du signal radio-électrique. En effet, la fréquence intermédiaire du signal FI généré par le mélangeur M est égale à la différence entre la fréquence radio et la fréquence du signal de sortie Vco de l'oscillateur OSC. La valeur de la fréquence intermédiaire étant fixée, ce qui est par exemple réalisé au moyen d'un filtrage passe-bande, non représenté sur la présente figure, effectué en sortie du mélangeur M, la fréquence du signal radio-électrique sélectionné dépend uniquement de la fréquence du signal Vco. En situation de verrouillage, la fréquence du signal Vco est égale à R fois celle du signal Vref. La valeur du signal de commande CMD détermine donc la fréquence radio du signal radio-électrique RF qui sera exploité après la sélection effectuée par le dispositif.

Les harmoniques les plus néfastes au fonctionnement de ce dispositif sont ceux qui ont des fréquences égales à FLO, FLO/4 et FLO/8. Comme on l'a vu précédemment, ces harmoniques peuvent être supprimés grâce à l'utilisation d'un diviseur de fréquence programmable DIV conforme à l'invention.

## Revendications

1. Circuit intégré comprenant un diviseur de fréquence muni d'une entrée symétrique destinée à recevoir un signal ayant une première fréquence, et d'une sortie symétrique destinée à délivrer un signal ayant une deuxième fréquence dont la valeur est 2*N fois inférieure à celle de la première fréquence, où N est un nombre entier au moins égal à 2, chacune munie d'une entrée symétrique de données, d'une entrée symétrique d'horloge et d'une sortie symétrique de données, **caractérisé en ce que** le diviseur de fréquence comporte 2*N bascules mémoire, la sortie de données de la i_{ème} bascule mémoire de rang i étant reliée, pour i=1 à 2*N-1, à l'entrée de données de la bascule de rang i+1, la sortie de données de la bascule de rang 2*N étant connectée avec croisement à l'entrée de données de la bascule de rang 1, la sortie de données de l'une des bascules constituant la sortie du circuit diviseur de fréquence, l'entrée d'horloge de chaque bascule de rang impair étant reliée à l'entrée du circuit diviseur de fréquence, l'entrée d'horloge de chaque bascule de rang pair étant connectée avec croisement à la dite entrée.

2. Circuit intégré selon la revendication 1 où les bascules mémoires sont du type ECL.

3. Circuit intégré comprenant un diviseur de fréquence programmable muni d'une première entrée destinée à recevoir un signal ayant une fréquence dite fréquence d'entrée, d'une deuxième entrée destinée à recevoir un signal dit de commande, et d'une sortie, le diviseur de fréquence programmable comportant :
. un premier diviseur de fréquence muni d'une entrée formant l'entrée du diviseur de fréquence programmable, et d'une sortie destinée à délivrer un signal ayant une fréquence dite intermédiaire dont la valeur est 2*P fois inférieure à celle de la fréquence d'entrée, où P est un nombre entier prédéterminé,
. un deuxième diviseur de fréquence muni d'une entrée reliée à la sortie du premier diviseur de fréquence, et d'une sortie formant la sortie du diviseur de fréquence programmable et destinée à délivrer un signal ayant une fréquence, dite de sortie, dont la valeur est K fois inférieure à celle de la fréquence intermédiaire, où K est un nombre réel dont la valeur est déterminée par la valeur du signal de commande,
**caractérisé en ce que** le premier diviseur de fréquence comporte au moins un circuit diviseur de fréquence conforme à la revendication 1 ou 2, P étant supérieur ou égal à N.

4. Dispositif de sélection muni d'une entrée dite de signal destinée à recevoir un signal radio-électrique, d'une deuxième entrée dite de commande destinée à recevoir un signal de commande définissant la fréquence d'un signal radio-électrique à sélectionner, et d'une sortie, dispositif comportant :
. un oscillateur muni d'une entrée dite de réglage et d'une sortie destinée à délivrer un signal dont la fréquence dépend de la valeur d'un signal appliqué à son entrée de réglage,
. un mélangeur muni d'une première entrée, formant l'entrée de signal du dispositif, d'une deuxième entrée reliée à la sortie de l'oscillateur, et d'une sortie, formant la sortie du dispositif, destinée à délivrer un signal dont la fréquence est égale à la différence entre la fréquence du signal reçu sur sa première entrée et celle du signal reçu sur sa deuxième entrée,
. un diviseur de fréquence programmable muni d'une première entrée reliée à la sortie de l'oscillateur, d'une deuxième entrée formant l'entrée de commande du dispositif, et d'une sortie destinée à délivrer un signal dont la fréquence est définie par la valeur du signal de commande,
. un détecteur de phase, muni d'une première entrée destinée à recevoir un signal dit de référence dont la fréquence est fixe, d'une deuxième entrée reliée à la sortie du diviseur de fréquence, et d'une sortie reliée à l'entrée de réglage de l'oscillateur, et muni de moyens pour délivrer sur sa sortie un signal dont la valeur dépend de la différence entre les phases de ses signaux d'entrée,
dispositif **caractérisé en ce que** le diviseur de fréquence programmable est conforme à la revendication 3.

## Patentansprüche

1. Integrierte Schaltung mit einem Frequenzteiler, versehen mit einem symmetrischen Eingang für den Erhalt eines Signals mit einer ersten Frequenz und einem symmetrischen Ausgang für die Abgabe eines Signals mit einer zweiten Frequenz, deren Wert 2*N-mal kleiner als der der ersten Frequenz ist, wobei N eine Ganzzahl mindestens gleich 2 ist, jeweils mit einem symmetrischen Dateneingang, einem symmetrischen Uhreingang und einem symmetrischen Datenausgang ausgestattet, **dadurch gekennzeichnet, dass** der Frequenzteiler 2*N Speicher-Flipflops enthält, der Datenausgang des i-ten Speicher-Flipflops von Rang i für i=1 bis 2*N-1, mit dem Dateneingang des Flipflops von Rang i*1 verbunden ist, wobei der Datenausgang des Flipflops von Rang 2*N über die Kreuzung an den Dateneingang des Flipflops von Rang 1 angeschlossen ist, der Datenausgang einer der Flipflops den Ausgang der Frequenzteilerschaltung bildet, der Uhreingang jedes Flipflops ungeraden Rangs mit dem Eingang der Frequenzteilerschaltung verbunden ist und der Uhreingang jedes Flipflops geraden Rangs über die Kreuzung an den besagten Eingang angeschlossen ist.

2. Integrierte Schaltung nach Anspruch 1, in der die Speicher-Flipflops vom Typ ECL sind.

3. Integrierte Schaltung mit einem programmierbaren Frequenzteiler, mit einem ersten Eingang für den Erhalt eines Signals mit einer so genannten Eingangsfrequenz, einem zweiten Eingang für den Erhalt eines so genannten Steuersignals und einem Ausgang versehen, wobei der programmierbare Frequenzteiler enthält:
. einen ersten Frequenzteiler mit einem Eingang, der den Eingang des programmierbaren Frequenzteilers bildet, und einem Ausgang für die Abgabe eines Signals mit einer so genannten Zwischenfrequenz, deren Wert 2*P-mal kleiner als der der Eingangsfrequenz ist, wobei P eine vorbestimmte Ganzzahl ist,
. einen zweiten Frequenzteiler mit einem Eingang, der mit dem Ausgang des ersten Frequenzteilers verbunden ist, und einem Ausgang, der den Ausgang des programmierbaren Frequenzteilers bildet und dafür bestimmt ist, ein Signal mit einer so genannten Ausgangsfrequenz abzugeben, deren Wert K-mal kleiner als der der Zwischenfrequenz ist, wobei K eine reelle Zahl ist, deren Wert vom Wert des Steuersignals festgelegt wird, **dadurch gekennzeichnet, dass** der erste Frequenzteiler mindestens eine Frequenzteiler nach Anspruch 1 oder 2 aufweist, wenn P größer oder gleich groß wie N ist.

4. Auswahleinrichtung mit einem so genannten Signaleingang für den Erhalt eines Funksignals, einem zweiten so genannten Steuereingang für den Erhalt eines Steuersignals, das die Frequenz eines auszuwählenden Funksignals definiert, und einem Ausgang, wobei die Einrichtung enthält:
. einen Oszillator mit einem so genannten Regeleingang und einem Ausgang für die Abgabe eines Signals, dessen Frequenz vom Wert eines seinem Regeleingang zugeführten Signals abhängt,
. einen Mischer mit einem ersten Eingang, der den Signaleingang der Einrichtung bildet, einem zweiten Eingang, mit dem Ausgang des Oszillators verbunden, und einem Ausgang, der den Ausgang der Einrichtung bildet, dafür bestimmt, ein Signal abzugeben, dessen Frequenz gleich der Differenz zwischen der Frequenz des an seinem ersten Eingang erhaltenen Signals und des an seinem zweiten Eingang erhaltenen Signals ist,
. einen programmierbaren Frequenzteiler mit einem ersten Eingang, mit dem Ausgang des Oszillators verbunden, einem zweiten Eingang, der den Eingang der Steuereinrichtung bildet, und einem Ausgang, dafür bestimmt, ein Signal abzugeben, dessen Frequenz vom Wert des Steuersignals definiert wird,
. einen Phasendetektor mit einem ersten Eingang für den Erhalt eines so genannten Bezugssignals, dessen Frequenz fest ist, und einem zweiten Eingang, mit dem Ausgang des Frequenzteilers verbunden, und einem mit dem Regeleingang des Oszillators verbundenen Ausgang und mit Verfahren versehen, um an seinem Ausgang ein Signal abzugeben, dessen Wert von der Differenz zwischen den Phasen seiner Eingangssignale abhängt,
**dadurch gekennzeichnete** Einrichtung, dass der programmierbare Frequenzteiler dem Anspruch 3 entspricht.

## Claims

1. An integrated circuit comprising a frequency divider having a symmetrical input which is intended to receive a signal having a first frequency, and a symmetrical output which is intended to supply a signal having a second frequency whose value is 2*N times lower than that of the first frequency, in which N is an integer which is at least equal to 2, each having a symmetrical data input, a symmetrical clock input and a symmetrical data output, **characterized in that** the frequency divider comprises 2*N memory cells, the data output of the i^{th} memory cell of rank i being connected, for i = 1 to 2*N-1, to the data input of the memory cell of rank i+1, the data output of the memory cell of rank 2*N being cross-connected to the data input of the memory cell of rank 1, the data output of one of the memory cells constituting the output of the frequency divider circuit, the clock input of each memory cell of an odd rank being connected to the input of the frequency divider circuit, the clock input of each memory cell of an even rank being cross-connected to said input.

2. An integrated circuit as claimed in claim 1, wherein the memory cells are of the ECL type.

3. An integrated circuit comprising a programmable frequency divider having a first input which is intended to receive a signal having an input frequency, a second input which is intended to receive a control signal, and an output, the programmable frequency divider comprising:
. a first frequency divider having an input constituting the input of the programmable frequency divider, and an output which is intended to supply a signal having an intermediate frequency whose value is 2*P times lower than that of the input frequency, in which P is a predetermined integer,
. a second frequency divider having an input connected to the output of the first frequency divider, and an output constituting the output of the programmable frequency divider, which output is intended to supply a signal having an output frequency whose value is K times lower than that of the intermediate frequency, in which K is a real number whose value is determined by the value of the control signal,
**characterized in that**, with P being higher than or equal to N, the first frequency divider comprises at least a frequency divider circuit as claimed in claim 1 or 2.

4. A selection device having a signal input which is intended to receive a radio-electric signal, a second control input which is intended to receive a control signal defining the fequency of a radio-electric signal to be selected, and an output, said device comprising:
. an oscillator having a tuning input and an output which is intended to supply a signal whose frequency depends on the value of a signal applied to its tuning input,
. a mixer having a first input constituting the signal input of the device, a second input connected to the output of the oscillator, and an output constituting the output of the device, which output is intended to supply a signal whose frequency is equal to the difference between the frequency of the signal received at its first input and that of the signal received at its second input,
. a programmable frequency divider having a first input connected to the output of the oscillator, a second input constituting the control input of the device, and an output which is intended to supply a signal whose frequency is defined by the value of the control signal,
. a phase detector having a first input which is intended to receive a reference signal whose frequency is fixed, a second input connected to the output of the frequency divider, and an output connected to the tuning input of the oscillator, and provided with means for supplying, at its output, a signal whose value depends on the difference between the phases of its input signals,
said device being **characterized in that** the programmable frequency divider is a frequency divider as claimed in claim 3.
